# EUROPEAN PATENT APPLICATION

(11) **EP 4 435 987 A1**
(43) Date of publication of application: **25.09.2024**
(21) Application number: 24164858.3
(22) Date of filing: 20.03.2024
(51) Int. Cl.: H02H 3/16, H02H 9/08, G01R 31/52

(54) **IDENTIFYING LOCATION OF AND CLEARING OF GROUND FAULTS IN MIDPOINT GROUNDED DC SYSTEMS**

(30) Priority: 20.03.2023 US 202318123633
(71) Applicant: Hamilton Sundstrand Corporation, Charlotte, NC 28217-4578 (US)
(72) Inventor: HEGLUND, William S., Rockford, IL (US); SEAGREN, Robert L., Rockford, IL (US)
(74) Representative: Dehns

(57) **Abstract**

A power supply system is configured to provide power to a load connected between first and second connectors. The system includes a generator (108) that produces an alternating current generator output. A rectifier (110) receives the alternating current generator output and converts it into a direct current output and provides the direct current (DC) output between the first and second connectors. A filter (112) is connected to the rectifier (110) and between the connectors to smooth the DC output. The filter (112) includes a midpoint configured to be connected to ground. A positive fault locating resistor (118, 126) is switchably connected to one of the first and second connectors by a switch configured to be normally open, and to switch closed upon detection of a ground fault so the positive ground fault locating resistor (118, 126) can provide a sustained level current for locating and clearing the ground fault.

## Description

### BACKGROUND

### 1. Field

The present disclosure relates to power systems, and more particularly to ground fault location and clearing in midpoint grounded DC systems.

### 2. Description of Related Art

The system grounding approach used for a +/-VDC electrical system can have a significant impact in the response of the system during a ground fault. A system with the ground connected at the generator neutral can supply sustained DC current to clear the ground fault. However, if the total generator current during the fault is greater than the foldback current in the controller, the bus voltage may decrease or collapse. Also, the DC voltage ripple during the fault increases significantly. A system with the ground connected at the midpoint of the DC filter has less common mode voltage ripple. However, the system is not able to supply a sustained DC current to clear the ground fault.

The conventional techniques have been considered satisfactory for their intended purpose. However, there is an ever present need for improved systems and methods for locating and clearing ground faults in DC power systems. This disclosure provides a solution for this need.

### SUMMARY

A power supply system is configured to provide power to a load connected between first and second connectors. The system includes a generator that produces an alternating current generator output. A rectifier receives the alternating current generator output and converts it into a direct current output and provides the direct current (DC) output between the first and second connectors. A filter is connected to the rectifier and between the connectors to smooth the DC output. The filter includes a midpoint configured to be connected to ground. A positive fault locating resistor is switchably connected to one of the first and second connectors by a switch configured to be normally open, and to switch closed upon detection of a ground fault so the positive ground fault locating resistor can provide a sustained level current for locating and clearing the ground fault.

The positive fault locating resistor can be switchably connected to the first connector by a first switch configured to be normally open, and to switch closed upon detection of a positive ground fault so the positive ground fault locating resistor can provide a sustained level current for locating and clearing the positive ground fault.. A negative fault locating resistor can be switchably connected to the second connector by a second switch configured to be normally open, and to switch closed upon detection of a negative ground fault so the negative ground fault locating resistor can provide a sustained level current for locating and clearing the negative ground fault.

A controller can be operatively connected to the first and second switches and to a sensor system. The controller can include machine readable instructions configured to cause the controller to:
keep the first and second switches normally open;
upon detection of a ground fault, close at least one of the first and second switches to provide a path for a limited and detectible amount of current to the ground fault after the ground fault has been detected;
determine location of the ground fault using the limited and detectable amount of current in the first and second connectors; and
open a contactor to clear the ground fault.

The machine readable instructions can be configured to cause the controller to detect the ground fault as a shift in rail to ground voltage in the first or second connector. Determining location of the ground fault can be based on the controller monitoring the limited and detectable amount of current in the first and second connectors.

The first and second positive fault locating resistors can each have a resistance configured to provide the limited and detectable amount of current. A contactor can be connected to the first connector that can open and close to clear the ground fault if the ground fault is on a side of the load connected to the first connector. A contactor can be connected to the second connector that can open and close to clear the ground fault if the ground fault is on a side of the load connected to the second connector. The output filter can include two capacitors and the midpoint is between the two capacitors. The ground can be external to the generator. The ground can be an airframe ground.

A method of clearing a fault in a system as described above includes keeping the switch or switches normally open. Upon detection of a ground fault, the method includes closing the switch or switches to provide a path for a limited and detectible amount of current to the ground fault after the ground fault has been detected. The method includes determining location of the ground fault using the limited and detectable amount of current in the first and second connectors, and opening a contactor to clear the ground fault.

The method can include detecting the ground fault as a shift in rail to ground voltage in the first or second connector. Determining location of the ground fault can be based on monitoring the limited and detectable amount of current in the first and second connectors. A method of using a system as described above can include closing the switch during initial generator power-up to determine if a ground fault exists in the generator, the rectifier, or the filter.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic view of an embodiment of a system constructed in accordance with the present disclosure, showing the positive fault locating resistors; and
Fig. 2 is a set of voltage and current graphs over a given time frame for the system of Fig. 1, showing currents and voltages during a ground fault and clearing the ground fault for source current, fault current, positive to ground voltage, ground to negative voltage, and bus voltage over the same time frame.

### DETAILED DESCRIPTION OF THE PREFERRED EMBODIMENTS

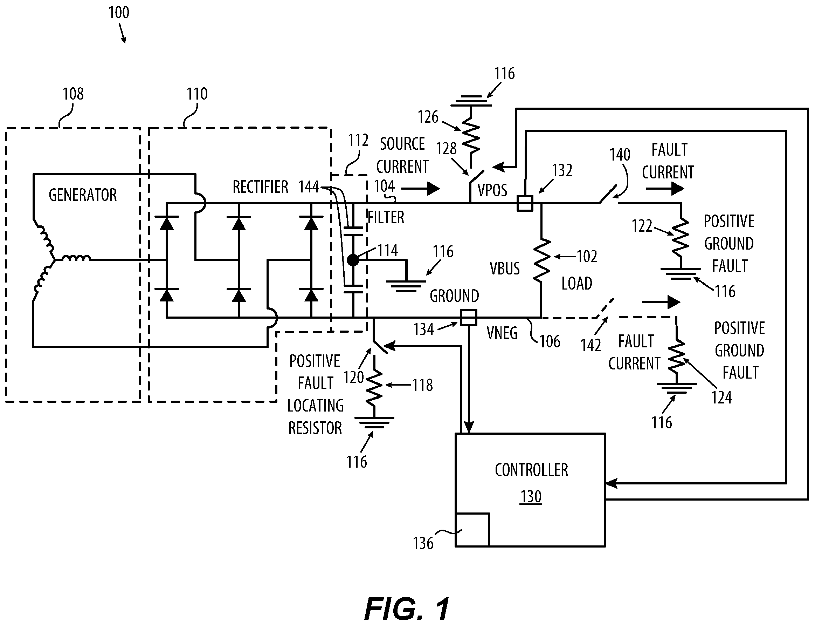

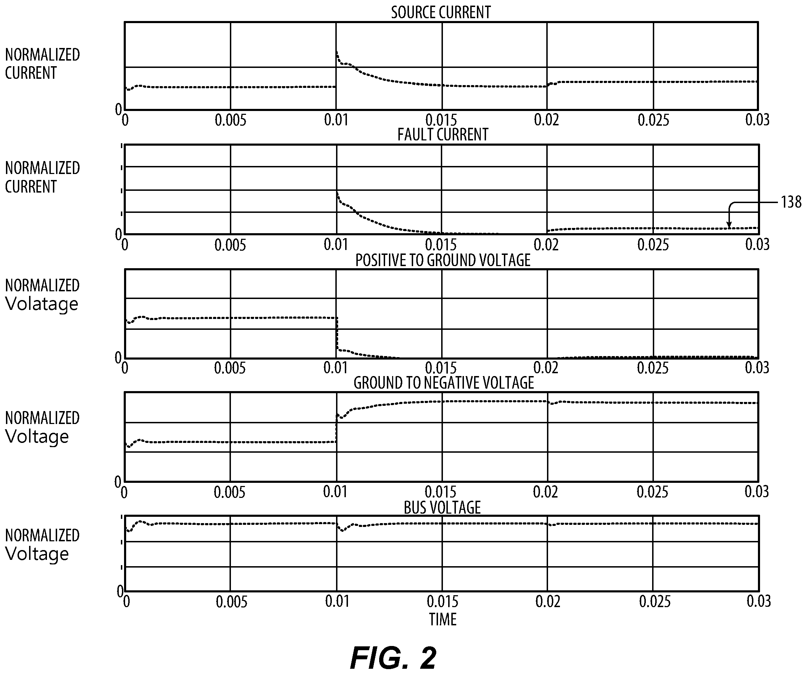

Reference will now be made to the drawings wherein like reference numerals identify similar structural features or aspects of the subject disclosure. For purposes of explanation and illustration, and not limitation, a partial view of an embodiment of a system in accordance with the disclosure is shown in Fig. 1 and is designated generally by reference character 100. Other embodiments of systems in accordance with the disclosure, or aspects thereof, are provided in Fig. 2, as will be described. The systems and methods described herein can be used to supply a small, sustained DC current sufficient for identifying the existence, location and clearing a ground fault in a midpoint grounded DC electric system.

The power supply system 100 is configured to provide power to a load 102 connected between first and second connectors 104, 106. The system 100 includes a generator 108 that produces an alternating current generator output. A rectifier 110 receives the alternating current generator output and converts it into a direct current output and provides the direct current (DC) output between the first and second connectors 104, 106. Although shown for a single rectifier, the approach could be applied to rectifiers connected in parallel. A filter 112 is connected to the rectifier 110 and between the connectors 104, 106 to smooth the DC output. The filter 112 includes a capacitor midpoint 114 that can be configured to be connected to ground 116. Instead of connecting to the midpoint of the two series capacitors, the midpoint of two series resistors can be used for the ground connection. The output filter 112 includes two capacitors 144 and the capacitor midpoint 114 that is between the two capacitors 144. Two resistors can also be connected in series between the first and second connectors 104, 106 to produce a resistor midpoint. The resistor midpoint can be configured to be connected to ground 116. The ground 116 is external to the generator 108, and can be an airframe ground.

A positive fault locating resistor 118 is switchably connected to negative connector 106 (Vneg) by a first switch 120. For a positive rail ground fault 140/122, closing switch 120 would provide a path for the current from the positive rail though the ground fault to the negative rail. The first switch 120 is configured to be normally open, and to switch closed upon detection of a ground fault 122, so the positive ground fault locating resistor 118 can provide a sustained level current for locating and clearing the ground fault 122.

A negative fault locating resistor 126 is switchably connected to the positive connector 104 (Vpos) by a second switch 128. The second switch 128 is configured to be normally open, and to switch closed upon detection of a ground fault, 124 so the negative ground fault locating resistor 126 can provide a sustained level current for locating and clearing the ground fault 124.

In Fig. 1, a contactor 140 is shown connected to the first connector 104. The contactor 140 can open and close to clear the ground fault 122 if the ground fault is on a the positive side of the load 102. A contactor 142 is shown connected to the second connector 106 that can open and close to clear the ground fault 124 if the ground fault is on the negative side of the load 102. Those skilled in the art will readily appreciate that these loads 122, 124 and switches 140, 142 are simulation artifacts for applying a simulated ground fault. In a real implementation, these faults protected for would be on rails 104 or 106. In a real system there may be a contactor to isolate a load shortly after the filter to allow isolation of the rails 104 and 106. Another contactor location could be between the load (102) and feeds/rails 104 and 106.

A controller 130 is operatively connected to control opening and closing of the first and second switches 118, 128 and to a sensor system for feedback. The sensor system including sensor packages 132, 134 which are connected to sense voltage and/or current in the first and second connectors 104, 106, respectively. The controller 130 includes machine readable instructions 136 configured to cause the controller to:
keep the first and second switches 118, 128 normally open;
upon detection of a positive ground fault 122, e.g. at time = 0.01 seconds in Fig. 2, close switch 120, e.g. at time = 0.02 seconds in Fig. 2, to provide a path for a limited and detectible amount of current 138, labeled in Fig. 2, to the ground fault 122 after the ground fault 122 has been detected;
determine location of the ground fault 122, using the limited and detectable amount of current 138, labeled in Fig. 2, in the first and second connectors 104, 106; and
open an appropriate one of the contactors 140 to clear the ground fault 122. Once the ground fault 140 has been detected and the appropriate action has been taken to isolate the fault, open the positive ground fault detecting switch 120 and resume normal operation.

A similar sequence will occur if a negative ground fault occurs and the negative ground fault detecting switch 128 and resistor 126 are used to identify and locate the ground fault 124.

The machine readable instructions 136 are configured to cause the controller 130 to detect the ground fault 122, 124 as a shift in rail to ground voltage in the first or second connector 104, 106. Determining location of the ground fault 122, 124 is based on the controller 130 monitoring the limited and detectable amount of current 138, labeled in Fig. 2, in the first and second connectors 104, 106. If the limited detectable current 138, labeled in Fig. 2, is detected in connector 104, e.g. by feedback to the controller 130 from the sensor package 132, then the ground fault 122 is present and the controller 130 can command the contactor 140 open to clear the fault, or it could deexcite the generator in a system that uses a synchronous machine, or it could shut down the rectifier if a active rectifier topolgy is used. Again the contactor 140 may not exist in a real implementation of the system as located in Fig. 1 for simulation purposes. Both rails 104, 106 can be opened, e.g. from a load 102, if a fault is detected. By the same reasoning, if the limited detectable current 138, labeled in Fig. 2, is detected in connector 106, e.g. by feedback to the controller 130 from the sensor package 134, then the ground fault 124 is present and the controller 130 can command for clearing the fault. Smaller current sensors, connected in series with the fault detecting switches 120 128, could be used to detect the relatively small ground fault currents. This could improve the accuracy of detecting and measuring the ground fault current. The first and second fault locating resistors 118, 126 each have a resistance configured to provide the limited and detectable amount of current 138 labeled in Fig. 2. The machine readable instructions 136 can include logic for the controller 130 to determine if the ground fault 122, 124 exists in the generator 108, the rectifier 110, or the filter 112.

The method can include the controller 130 detecting the ground fault as a shift in rail to ground voltage in the first or second connector 106, 104. This method can be used during normal operation of the generator 108 powering the load 102. The method can also include closing the switches 120, 128 during initial power-up of the generator 108 to determine if a ground fault 122, 124 exists in the generator 108, the rectifier 110, or the filter 112.

Systems and methods as disclosed herein provide benefits of systems with the midpoint of the DC filter, such as low common mode voltage ripple. Systems and methods as disclosed herein can also provide the benefit of sustained DC current to clear ground faults.

The methods and systems of the present disclosure, as described above and shown in the drawings, provide for supplying a small, sustained DC current sufficient for identifying the existence, location and clearing a ground fault in a midpoint grounded DC electric system. While the apparatus and methods of the subject disclosure have been shown and described with reference to preferred embodiments, those skilled in the art will readily appreciate that changes and/or modifications may be made thereto without departing from the scope of the subject disclosure.

## Claims

1. A power supply system to provide power to a load connected between first and second connectors, the system comprising:
a generator (108) that produces an alternating current generator output;
a rectifier (110) that receives the alternating current generator output and converts it into a direct current output and provides the direct current (DC) output between the first and second connectors;
a filter (112) connected to the rectifier (110) and between the connectors that smooths the DC output, the filter (112) including a midpoint configured to be connected to ground; and
a fault locating resistor (118, 126) switchably connected to the second connector by a switch configured to be normally open, and to switch closed upon detection of a ground fault so the fault locating resistor (118, 126) can provide a path for a sustained level of current for locating and clearing the ground fault.

2. The system as recited in claim 1, wherein the fault locating fault locating resistor (118, 126) is a positive fault locating resistor (118, 126) that switchably connects to the second connector for locating and clearing a positive ground fault ground fault, and further comprising:
a negative fault locating resistor (118, 126) switchably connected to the first connector by a second switch configured to be normally open, and to switch closed upon detection of a ground fault so the negative ground fault locating resistor (118, 126) can provide a path for a sustained level of current for locating and clearing a negative ground fault.

3. The system as recited in claim 2, further comprising a controller operatively connected to the first and second switches and to a sensor system, wherein the controller includes machine readable instructions configured to cause the controller to:
keep the first and second switches normally open;
upon detection of a ground fault, close one of the first or second switches to provide a path for a limited and detectible amount of current to the ground fault after the ground fault has been detected; and
determine location of the ground fault using the limited and detectable amount of current in the first and second connectors;
and clear the ground fault.

4. The system as recited in claim 3, wherein the machine readable instructions are configured to cause the controller to:
detect the ground fault as a shift in rail to ground voltage in the first or second connector.

5. The system as recited in claim 4, wherein determining location of the ground fault is based on the controller monitoring the limited and detectable amount of current in the first and second connectors.

6. The system as recited in claim 4, wherein the first and second positive fault locating resistors (118, 126) each have a resistance configured to provide the limited and detectable amount of current.

7. The system as recited in any preceding claim, further comprising:
a contactor connected to the first connector that can open and close to clear the ground fault if the ground fault is on a side of the load connected to the first connector.

8. The system as recited in any preceding claim, further comprising:
a contactor connected to the second connector that can open and close to clear the ground fault if the ground fault is on a side of the load connected to the second connector.

9. The system as recited in any preceding claim, wherein the output filter (112) includes two or more capacitors and the midpoint is between the two capacitors.

10. The system as recited in any preceding claim, wherein the ground is external to the generator (108).

11. The system as recited in any preceding claim, wherein the ground is an airframe ground.

12. A method of clearing a fault in a system as recited in any preceding claim comprising:
keeping the switch normally open;
upon detection of a ground fault, closing the switch to provide a path for a limited and detectible amount of current to the ground fault after the ground fault has been detected;
determining location of the ground fault using the limited and detectable amount of current in the first and second connectors; and
opening a contactor to clear the ground fault.

13. The method as recited in claim 12, further comprising:
detecting the ground fault as a shift in rail to ground voltage in the first or second connector.

14. The method as recited in claim 12, wherein determining location of the ground fault is based on monitoring the limited and detectable amount of current in the first and second connectors.

15. A method of using a system as recited in any preceding claim, comprising:
closing the switch during initial generator power-up to determine if a ground fault exists in the generator (108), the rectifier (110), or the filter (112).
